# EUROPEAN PATENT SPECIFICATION

(11) **EP 3 899 197 B1**
(45) Date of publication and mention of the grant of the patent: **10.05.2023**
(21) Application number: 19832797.5
(22) Date of filing: 11.12.2019
(51) Int. Cl.: E21B 41/00, G01V 99/00, G06F 17/00

(54) **OPTIMIZING RESERVOIR SIMULATION RUNTIME AND STORAGE**
OPTIMIERUNG VON RESERVOIRSIMULATIONSLAUFZEIT UND -SPEICHERUNG
OPTIMISATION DE L'EXÉCUTION ET DU STOCKAGE DE SIMULATION DE RÉSERVOIR

(30) Priority: 17.12.2018 US 201816222007
(43) Date of publication of application: 27.10.2021
(73) Proprietor: Saudi Arabian Oil Company, Dhahran 31311 (SA)
(72) Inventor: BADDOURAH, Majdi A., Dhahran 31311 (SA); AL-TURKI, Ali A., Dhahran 31311 (SA)
(74) Representative: Fish & Richardson P.C.
(86) International application number: PCT/US2019/065693
(87) International publication number: WO 2020/131520

(56) References cited:
- US-A1- 2011 313 745
- US-A1- 2016 123 120
- Erin Hastings ET AL: "Optimization of Large-Scale, Real-Time Simulations by Spatial Hashing", , 1 January 2014 (2014-01-01), XP055677991, Retrieved from the Internet: URL:https://www.researchgate.net/publicati on/228958917_Optimization_of_large-scale_r eal-time_simulations_by_spatial_hashing [retrieved on 2020-03-19]

## Description

### CLAIM OF PRIORITY

This patent claims priority to U.S. Patent Application No. 16/222,007 filed on December 17, 2018.

### BACKGROUND

The present disclosure applies to the storage and use of reservoir structural files used in reservoir simulations (for example, for oil wells). Reservoir structural file definitions can be a key input to reservoir simulations and models. The definitions can define how the reservoirs look, determine the level of detail of information that is stored, and represent a desired discretization for mathematical representation. The structure of reservoir structural files can be based on a function of flow zonation (for example, units), facies distribution, porosity and permeability, rock quality, well density, and fluid flow models. The facies distribution can define, for example, geological characteristics including rock formations, composition, and fossil content. Numerical reservoir simulation can be very resource intensive, requiring high-performance computing capacity and high-performance storage.

US 2016/0123120 describes a two-tiered file similarity detection. First, a file's metadata hashed from a database is used to filter similar files. Then, checksums for each file are compared to verify similarity before linking the files.

### SUMMARY

The present disclosure describes techniques that can be used for optimizing reservoir simulation runtime and storage by hashing reservoir model structural and initialization data. The invention is defined in the claims. In some implementations, a computer-implemented method, includes: calculating a checksum for model structural data produced from a reservoir simulation study; querying a hash table for the checksum; when a determination is made that the checksum exists in the hash table, generating soft links to physical locations of reservoir structure files containing the model structural data; and when a determination is made that the checksum does not exist in the hash table: generating new reservoir structure files for the model structural data; generating a new hash table entry containing record information identifying contents of the new reservoir structure files; and updating the hash table with the new hash table entry.

The previously described implementation is implementable using a computer-implemented method; a non-transitory, computer-readable medium storing computer-readable instructions to perform the computer-implemented method; and a computer-implemented system comprising a computer memory interoperably coupled with a hardware processor configured to perform the computer-implemented method/the instructions stored on the non-transitory, computer-readable medium.

The subject matter described in this specification can be implemented in particular implementations, so as to realize one or more of the following advantages. First, the techniques described in the present disclosure can reduce the use of finite high-performance storage resources used in numerical reservoir simulation. Second, optimization can occur on the digital footprint of reservoir model structural data. Third, unnecessary reservoir simulation input/output (I/O) can be avoided at the setup and initialization stage. Fourth, simulator overhead, including computation time, can be reduced at setup initialization. The savings in storage and computation time can improve the efficiency, for example, in assisted history matching, optimization, prediction, field development, and recovery and economic assessment reservoir simulation runs.

The details of one or more implementations of the subject matter of this specification are set forth in the Detailed Description, the accompanying drawings, and the claims. Other features, aspects, and advantages of the subject matter will become apparent from the Detailed Description, the claims, and the accompanying drawings.

### DESCRIPTION OF DRAWINGS

FIG. 1 is a flowchart showing examples of operations of a conventional process for generating and storing simulation model structural information, according to some implementations of the present disclosure.
FIG. 2 is a flowchart showing examples of operations of an optimized process for generating and storing simulation model structural information, according to some implementations of the present disclosure.
FIG. 3 is a flowchart of an example method for using a hash table to optimize storage of model structural data produced from a reservoir simulation study, according to some implementations of the present disclosure.
FIG. 4 is a block diagram illustrating an example computer system used to provide computational functionalities associated with described algorithms, methods, functions, processes, flows, and procedures as described in the instant disclosure, according to some implementations of the present disclosure.

Like reference numbers and designations in the various drawings indicate like elements.

### DETAILED DESCRIPTION

The following detailed description describes techniques for optimizing reservoir simulation runtime and storage by hashing reservoir model structural and initialization data. Various modifications, alterations, and permutations of the disclosed implementations can be made and will be readily apparent to those of ordinary skill in the art, and the general principles defined may be applied to other implementations and applications, without departing from scope of the disclosure. In some instances, details unnecessary to obtain an understanding of the described subject matter may be omitted so as to not obscure one or more described implementations with unnecessary detail and inasmuch as such details are within the skill of one of ordinary skill in the art. The present disclosure is not intended to be limited to the described or illustrated implementations, but to be accorded the widest scope consistent with the described principles and features.

In some implementations, grid data, including reservoir model structural data, can be stored in different formats. The formats can include, for example, cell-centered, corner-point geometry, or an unstructured format, such as perpendicular bisector (PEBI) gridding or its variations. Depending on a size of a model, the reservoir model structural data can usually be large enough to consume a considerable digital footprint, such as by consuming gigabytes of the finite high-performance disk storage. Significant processing time can also occur in the reservoir simulator at model setup and initialization. The reservoir model structure definition (for example, discretization) can remain unchanged after being generated once, as compared to the many times reservoir model structure definition is used for running simulations.

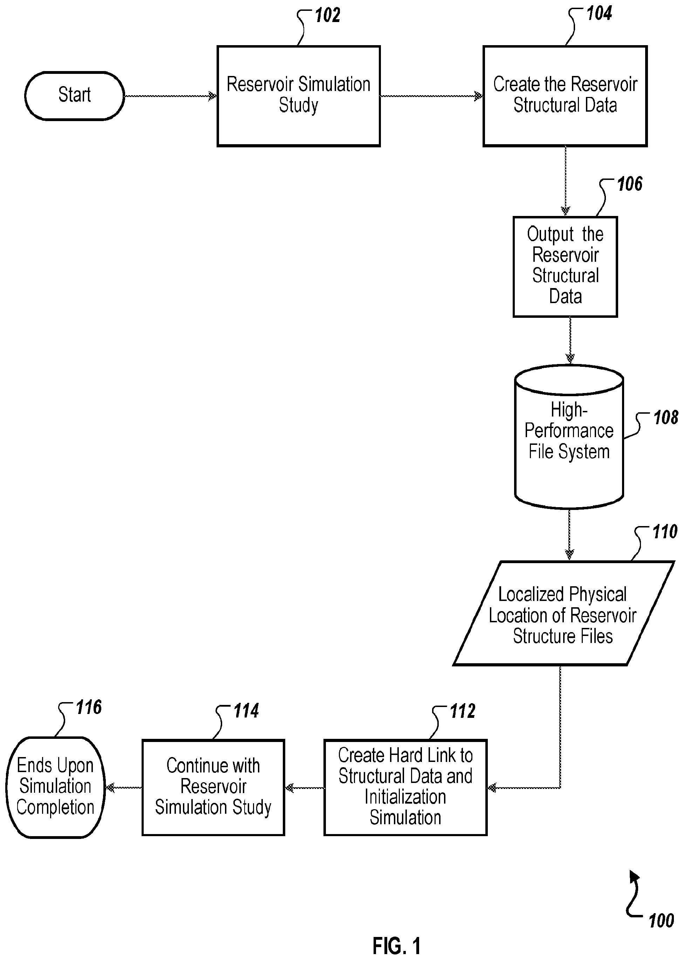

FIG. 1 is a flowchart showing examples of operations of a conventional process 100 for generating and storing simulation model structural information, according to some implementations of the present disclosure. The operations can be performed, for example, during a process used for modeling a reservoir of an oil well.

At 102, a reservoir simulation study is initiated. For example, a simulation can be started for a reservoir associated with an oil drilling operation.

At 104 reservoir structural data is generated. As an example, during execution of the reservoir simulation study, data for a cell (or other data point) in the reservoir structural data can be generated based on information in the reservoir at a particular location.

At 106, the reservoir structural data is output to a database. For example, the data for the cell can be output to a high-performance file system 108.

At 110, a localized physical location of reservoir structure files is generated. For example, in a conventional system, a localized physical location of the data can be used without regard to optimization, such as optimization described in the present disclosure.

At 112, a hard link to structural data is generated and initialized. As an example, the conventional system can generate a hard link to the newly generated physical location.

At 114, the reservoir simulation study continues. The reservoir simulation study can continue, for example, until the reservoir simulation study ends upon simulation completion at 116.

Process 100 lacks aspects of the present disclosure related to optimization. For example, process 100 lacks optimization of resources needed to write the simulation model structural information and high-performance storage utilization.

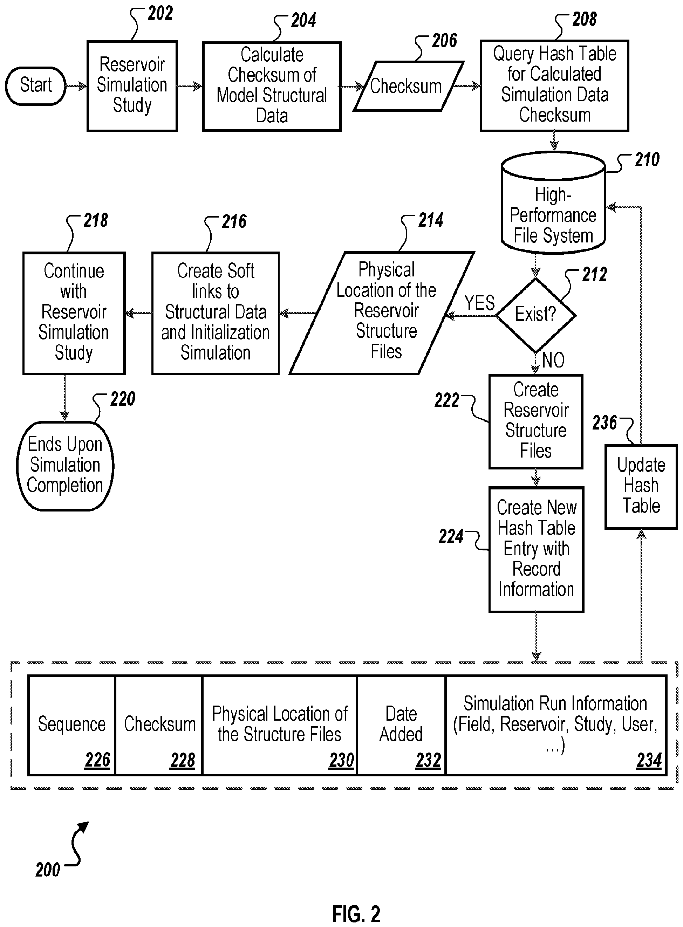

FIG. 2 is a flowchart showing examples of operations of an optimized process 200 for generating and storing simulation model structural information, according to some implementations of the present disclosure. The operations can be used, for example, for modeling a reservoir of an oil well. The optimized process 200 is an improvement over the conventional process 100, for example, because of the use of intermediate processes that reduce the time needed to write simulation model structural information and the use of high-performance storage utilization optimization. Specifically, optimized process 200 can serve as an intermediate processes between the simulation startup and commencing the actual numerical operations.

At 202, a reservoir simulation study is initiated. For example, a simulation can be started for a reservoir associated with an oil drilling operation.

In some implementations, an optimization agent can run in parallel with the simulation run right before the simulator commence initialization. For example, the optimization agent can perform the following. At 204, when the structural input data file can be accessed, a checksum 206 of the structural input data file can be calculated. At 208, using a hash table, the optimization agent can perform a lookup procedure for an n-tuple. For example, the hash table in a high-performance file system 210 can be queried to look up the calculated simulation data checksum. The look-up can correspond, for example, to one or more of a field, a grid name, a checksum, a physical location on disk, or an activity status.

At 212, a determination is made whether the checksum exists. The operation that occurs next in the optimized process 200 depends on the result of the look-up.

If the grid exists, for example, then the optimization agent can interrupt the simulation initialization and prevent the simulator from generating a grid file. At 214, a physical location of the reservoir structure files is accessed. At 216, instead of generating the grid file, a soft link that links the structural data to the simulation is generated. For example, the soft link can be generated with the actual model name to the actual grid file on the disk.

Soft links (also referred to as file links) can be generated to lead to simulation input files and simulation output files. By generating a soft link, numerical reservoir simulation input and output files can reside anywhere within a shared file system, without creating a need to move data between file systems. The present disclosure prevents the unnecessary creation of numerical model structural data (used in history matching runs) and simulator initial reservoir simulation model property files (used in prediction runs). An optimization agent can interrupt the simulation initialization, not allowing the simulator to generate grid or initialization files. Instead, the optimization agent can look up and associate the necessary data files through soft links. The look up procedure depends on the use of hash tables. At 218, processing can continue with the simulation study. At 220, the processing can end upon a determination that the simulation has complete.

If the grid does not already exist, for example, the grid output can be moved to a grid directory. At 222, reservoir structure files are generated. At 224, the optimization agent can generate an entry in the hash table with record information that includes the checksum of the input file and the name and the location of the actual grid file on the disk. For example, the record can include a sequence 226, a checksum 228, a physical location of the structure files 230, a date added 232, and simulation run information 234 (for example, identifying at least a field, a reservoir, a study, and a user). At 236, the hash table is updated in the high-performance file system 210.

The high-performance file system 210 can also be applied to prediction runs on initial reservoir simulation model property files. For example, initialization (or "init") binary files can store reservoir static and initial properties. The "init" binary files can be large enough so that any optimization that occurs saving disk storage or input/output (I/O) can considerably enhance the performance of the simulation run and positively impact the resource optimization. The optimized process 200 can be utilized during prediction runs, for example, because the "init" files do not change during prediction and optimization runs but are instead unique for those types of simulation runs (or studies). In some implementations, another lookup table (or hash table) can be generated for the "init" files with n-tuple entries. For example, each entry can include a field, an "init" file name, a checksum, a physical location on disk, and an activity status.

A prediction run can refer to a single numerical simulation run. A prediction study can refer to one or more prediction runs, such as recovery runs, reserves estimates, and single-well studies. Prediction numerical simulation runs can be supported using techniques of the present disclosure. Prediction studies can include recovery runs, reserves estimates, field development strategies, and single-well studies.

In some implementations, to improve data security, the grid and other associated information can be saved under the field working directories with proper access levels permissions. The permissions can be at user and user group levels, for example. Further, the grid and other associated information can adhere to the data lifecycle policies that are already in place. Further, access limitations and protections can be added so that, although the optimization agent has exclusive access to the hash table, the actual grid files are only accessible to authorized simulation runs performed for the field/reservoir under consideration.

An example of saved resources is provided for the present disclosure for comparison with conventions systems. For example, for a high-performance file system with a 40 GB grid file size and a number of history match runs of 300 runs, the disk space require on the conventional system required to store grid files can be 12,000 GB. After the implementation using techniques of the present disclosure, the storage requirement of the grid files can be 40 GB. For simulation model initialization, the time needed to read/write the grid file to disk can be five minutes, the number of history match runs can be 300 runs, and the time taken for grid I/O for 300 runs can be 25 hours.

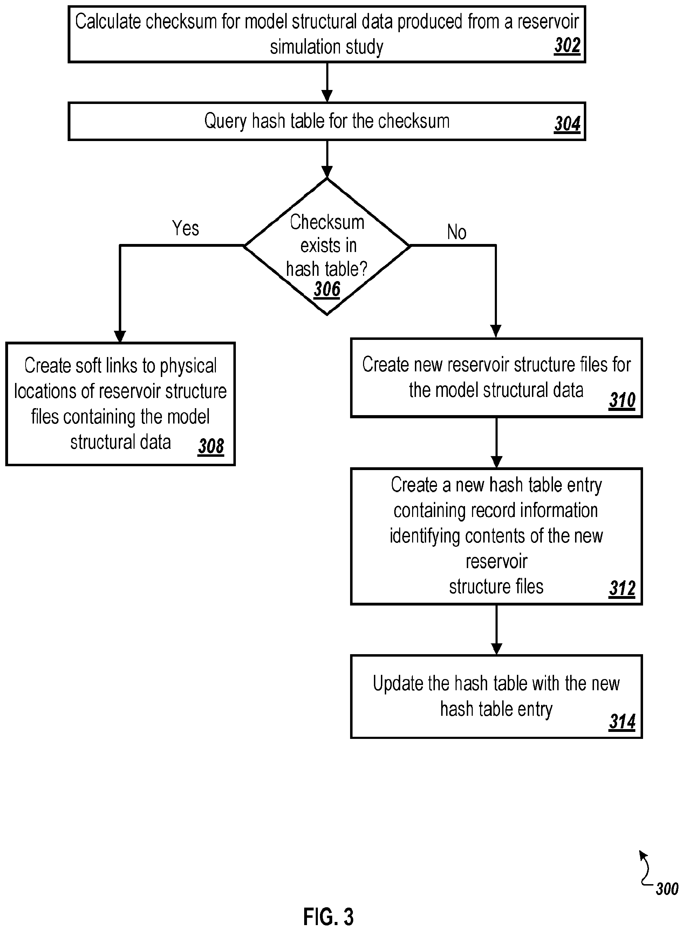

FIG. 3 is a flowchart of an example method 300 for using a hash table to optimize storage of model structural data produced from a reservoir simulation study, according to some implementations of the present disclosure. For clarity of presentation, the description that follows generally describes method 300 in the context of the other figures in this description. However, it will be understood that method 300 may be performed, for example, by any suitable system, environment, software, and hardware, or a combination of systems, environments, software, and hardware, as appropriate. In some implementations, various steps of method 300 can be run in parallel, in combination, in loops, or in any order.

At 302, a checksum is calculated for model structural data produced from a reservoir simulation study. For example, the checksum can be calculated based on information associated with the model structural data or metadata indicating the source of the information. The model structural data and the reservoir simulation study can be associated, for example, with a reservoir of an oil well.

At 304, a hash table is queried for the checksum. For example, querying the hash table for the checksum can include a query that is formulated using the checksum in combination with one or more of a field name, a grid name, a physical location on disk, or an activity status.

At 306, a determination is made whether the checksum exists in the hash table. For example, the results of the query can indicate a record-found or a record-not-found status result.

At 308, when a determination is made that the checksum exists in the hash table, soft links are generated to physical locations of reservoir structure files containing the model structural data. As an example, if the checksum exists, indicating that the reservoir structure files already exist, then the reservoir structure files can be used in their existing physical file locations. The soft links that are generated to physical locations of reservoir structure files can be filenames, pathnames, uniform resource locators (URLs), or some other links.

At 310, when a determination is made that the checksum does not exist in the hash table, new reservoir structure files are generated for the model structural data. For example, new reservoir structure files can store grid data that is generated in the format of the existing reservoir structure files. Example formats of the grid data include a cell-centered format, a corner-point geometry format, and an unstructured format, such as the PEBI gridding format. The new reservoir structure files can be stored, for example, in the high-performance file system 210.

At 312, a new hash table entry is generated containing record information identifying contents of the new reservoir structure files. As an example, the new hash table entry that is generated can be a record that contains a sequence, the checksum, the physical locations of the reservoir structure files, a date added, and simulation run information.

At 314, the hash table is updated with the new hash table entry. For example, hash table that is updated can be part of the high-performance file system 210.

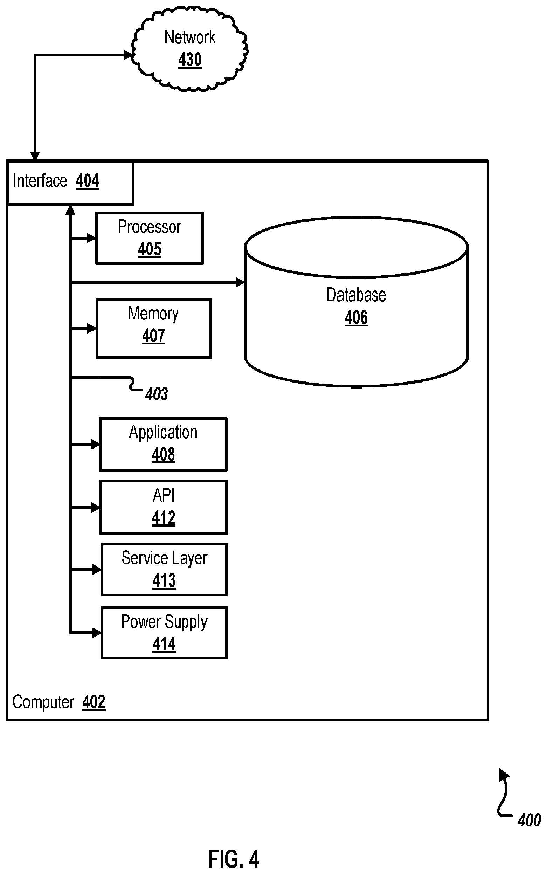

FIG. 4 is a block diagram of an example computer system 400 used to provide computational functionalities associated with described algorithms, methods, functions, processes, flows, and procedures, as described in the instant disclosure, according to some implementations of the present disclosure. The illustrated computer 402 is intended to encompass any computing device such as a server, desktop computer, laptop/notebook computer, wireless data port, smart phone, personal data assistant (PDA), tablet computing device, one or more processors within these devices, or any other suitable processing device, including physical or virtual instances (or both) of the computing device. Additionally, the computer 402 may comprise a computer that includes an input device, such as a keypad, keyboard, touch screen, or other device that can accept user information, and an output device that conveys information associated with the operation of the computer 402, including digital data, visual, or audio information (or a combination of information), or a graphical-type user interface (UI) (or GUI).

The computer 402 can serve in a role as a client, network component, a server, a database or other persistency, or any other component (or a combination of roles) of a computer system for performing the subject matter described in the instant disclosure. The illustrated computer 402 is communicably coupled with a network 430. In some implementations, one or more components of the computer 402 may be configured to operate within environments, including cloud-computing-based, local, global, or other environment (or a combination of environments).

At a high level, the computer 402 is an electronic computing device operable to receive, transmit, process, store, or manage data and information associated with the described subject matter. According to some implementations, the computer 402 may also include or be communicably coupled with an application server, email server, web server, caching server, streaming data server, or other server (or a combination of servers).

The computer 402 can receive requests over network 430 from a client application (for example, executing on another computer 402) and respond to the received requests by processing the received requests using an appropriate software application(s). In addition, requests may also be sent to the computer 402 from internal users (for example, from a command console or by other appropriate access method), external or third-parties, other automated applications, as well as any other appropriate entities, individuals, systems, or computers.

Each of the components of the computer 402 can communicate using a system bus 403. In some implementations, any or all of the components of the computer 402, hardware or software (or a combination of both hardware and software), may interface with each other or the interface 404 (or a combination of both), over the system bus 403 using an application programming interface (API) 412 or a service layer 413 (or a combination of the API 412 and service layer 413). The API 412 may include specifications for routines, data structures, and object classes. The API 412 may be either computer-language independent or dependent and refer to a complete interface, a single function, or even a set of APIs. The service layer 413 provides software services to the computer 402 or other components (whether or not illustrated) that are communicably coupled to the computer 402. The functionality of the computer 402 may be accessible for all service consumers using this service layer. Software services, such as those provided by the service layer 413, provide reusable, defined functionalities through a defined interface. For example, the interface may be software written in JAVA, C++, or other suitable language providing data in extensible markup language (XML) format or other suitable format. While illustrated as an integrated component of the computer 402, alternative implementations may illustrate the API 412 or the service layer 413 as stand-alone components in relation to other components of the computer 402 or other components (whether or not illustrated) that are communicably coupled to the computer 402. Moreover, any or all parts of the API 412 or the service layer 413 may be implemented as child or sub-modules of another software module, enterprise application, or hardware module without departing from the scope of this disclosure.

The computer 402 includes an interface 404. Although illustrated as a single interface 404 in FIG. 4, two or more interfaces 404 may be used according to particular needs, desires, or particular implementations of the computer 402. The interface 404 is used by the computer 402 for communicating with other systems that are connected to the network 430 (whether illustrated or not) in a distributed environment. Generally, the interface 404 comprises logic encoded in software or hardware (or a combination of software and hardware) and is operable to communicate with the network 430. More specifically, the interface 404 may comprise software supporting one or more communication protocols associated with communications such that the network 430 or interface's hardware is operable to communicate physical signals within and outside of the illustrated computer 402.

The computer 402 includes a processor 405. Although illustrated as a single processor 405 in FIG. 4, two or more processors may be used according to particular needs, desires, or particular implementations of the computer 402. Generally, the processor 405 executes instructions and manipulates data to perform the operations of the computer 402 and any algorithms, methods, functions, processes, flows, and procedures as described in the instant disclosure.

The computer 402 also includes a database 406 that can hold data for the computer 402 or other components (or a combination of both) that can be connected to the network 430 (whether illustrated or not). For example, database 406 can be an in-memory, conventional, or other type of database storing data consistent with this disclosure. In some implementations, database 406 can be a combination of two or more different database types (for example, a hybrid in-memory and conventional database) according to particular needs, desires, or particular implementations of the computer 402 and the described functionality. Although illustrated as a single database 406 in FIG. 4, two or more databases (of the same or combination of types) can be used according to particular needs, desires, or particular implementations of the computer 402 and the described functionality. While database 406 is illustrated as an integral component of the computer 402, in alternative implementations, database 406 can be external to the computer 402.

The computer 402 also includes a memory 407 that can hold data for the computer 402 or other components (or a combination of both) that can be connected to the network 430 (whether illustrated or not). Memory 407 can store any data consistent with this disclosure. In some implementations, memory 407 can be a combination of two or more different types of memory (for example, a combination of semiconductor and magnetic storage) according to particular needs, desires, or particular implementations of the computer 402 and the described functionality. Although illustrated as a single memory 407 in FIG. 4, two or more memories 407 (of the same or combination of types) can be used according to particular needs, desires, or particular implementations of the computer 402 and the described functionality. While memory 407 is illustrated as an integral component of the computer 402, in alternative implementations, memory 407 can be external to the computer 402.

The application 408 is an algorithmic software engine providing functionality according to particular needs, desires, or particular implementations of the computer 402, particularly with respect to functionality described in this disclosure. For example, application 408 can serve as one or more components, modules, or applications. Further, although illustrated as a single application 408, the application 408 may be implemented as multiple applications 408 on the computer 402. In addition, although illustrated as integral to the computer 402, in alternative implementations, the application 408 can be external to the computer 402.

The computer 402 can also include a power supply 414. The power supply 414 can include a rechargeable or non-rechargeable battery that can be configured to be either user- or non-user-replaceable. In some implementations, the power supply 414 can include power-conversion or management circuits (including recharging, standby, or other power management functionality). In some implementations, the power-supply 414 can include a power plug to allow the computer 402 to be plugged into a wall socket or other power source to, for example, power the computer 402 or recharge a rechargeable battery.

There may be any number of computers 402 associated with, or external to, a computer system containing computer 402, each computer 402 communicating over network 430. Further, the term "client," "user," and other appropriate terminology may be used interchangeably, as appropriate, without departing from the scope of this disclosure. Moreover, this disclosure contemplates that many users may use one computer 402, or that one user may use multiple computers 402.

Described implementations of the subject matter can include one or more features, alone or in combination.

For example, in a first implementation, a computer-implemented method according to claim 1 is described.

The foregoing and other described implementations can each, optionally, include one or more of the features according to claims 2 to 7.

In a second implementation, a non-transitory, computer-readable medium storing one or more instructions executable by a computer system to perform operations according to claim 8 is described.

In a third implementation, a computer-implemented system according to claim 9 is described.

Implementations of the subject matter and the functional operations described in this specification can be implemented in digital electronic circuitry, in tangibly embodied computer software or firmware, in computer hardware, including the structures disclosed in this specification and their structural equivalents, or in combinations of one or more of them. Software implementations of the described subject matter can be implemented as one or more computer programs, that is, one or more modules of computer program instructions encoded on a tangible, non-transitory, computer-readable computer-storage medium for execution by, or to control the operation of, data processing apparatus. Alternatively, or additionally, the program instructions can be encoded in/on an artificially generated propagated signal, for example, a machine-generated electrical, optical, or electromagnetic signal that is generated to encode information for transmission to suitable receiver apparatus for execution by a data processing apparatus. The computer-storage medium can be a machine-readable storage device, a machine-readable storage substrate, a random or serial access memory device, or a combination of computer-storage mediums.

The terms "data processing apparatus," "computer," or "electronic computer device" (or equivalent as understood by one of ordinary skill in the art) refer to data processing hardware and encompass all kinds of apparatus, devices, and machines for processing data, including by way of example, a programmable processor, a computer, or multiple processors or computers. The apparatus can also be, or further include special purpose logic circuitry, for example, a central processing unit (CPU), a field programmable gate array (FPGA), or an application-specific integrated circuit (ASIC). In some implementations, the data processing apparatus or special purpose logic circuitry (or a combination of the data processing apparatus or special purpose logic circuitry) may be hardware- or software-based (or a combination of both hardware- and software-based). The apparatus can optionally include code that creates an execution environment for computer programs, for example, code that constitutes processor firmware, a protocol stack, a database management system, an operating system, or a combination of execution environments. The present disclosure contemplates the use of data processing apparatuses with or without conventional operating systems, for example LINUX, UNIX, WINDOWS, MAC OS, ANDROID, IOS, or any other suitable conventional operating system.

A computer program, which may also be referred to or described as a program, software, a software application, a module, a software module, a script, or code can be written in any form of programming language, including compiled or interpreted languages, or declarative or procedural languages, and it can be deployed in any form, including as a stand-alone program or as a module, component, subroutine, or other unit suitable for use in a computing environment. A computer program may, but need not, correspond to a file in a file system. A program can be stored in a portion of a file that holds other programs or data, for example, one or more scripts stored in a markup language document, in a single file dedicated to the program in question, or in multiple coordinated files, for example, files that store one or more modules, sub-programs, or portions of code. A computer program can be deployed to be executed on one computer or on multiple computers that are located at one site or distributed across multiple sites and interconnected by a communication network. While portions of the programs illustrated in the various figures are shown as individual modules that implement the various features and functionality through various objects, methods, or other processes, the programs may instead include a number of sub-modules, third-party services, components, libraries, and such, as appropriate. Conversely, the features and functionality of various components can be combined into single components, as appropriate. Thresholds used to make computational determinations can be statically, dynamically, or both statically and dynamically determined.

The methods, processes, or logic flows described in this specification can be performed by one or more programmable computers executing one or more computer programs to perform functions by operating on input data and generating output. The methods, processes, or logic flows can also be performed by, and apparatus can also be implemented as, special purpose logic circuitry, for example, a CPU, an FPGA, or an ASIC.

Computers suitable for the execution of a computer program can be based on general or special purpose microprocessors, both, or any other kind of CPU. Generally, a CPU will receive instructions and data from and write to a memory. The essential elements of a computer are a CPU, for performing or executing instructions, and one or more memory devices for storing instructions and data. Generally, a computer will also include, or be operatively coupled to, receive data from or transfer data to, or both, one or more mass storage devices for storing data, for example, magnetic, magneto-optical disks, or optical disks. However, a computer need not have such devices. Moreover, a computer can be embedded in another device, for example, a mobile telephone, a personal digital assistant (PDA), a mobile audio or video player, a game console, a global positioning system (GPS) receiver, or a portable storage device, for example, a universal serial bus (USB) flash drive, to name just a few.

Computer-readable media (transitory or non-transitory, as appropriate) suitable for storing computer program instructions and data includes all forms of permanent/non-permanent or volatile/non-volatile memory, media and memory devices, including by way of example semiconductor memory devices, for example, random access memory (RAM), read-only memory (ROM), phase change memory (PRAM), static random access memory (SRAM), dynamic random access memory (DRAM), erasable programmable read-only memory (EPROM), electrically erasable programmable read-only memory (EEPROM), and flash memory devices; magnetic devices, for example, tape, cartridges, cassettes, internal/removable disks; magneto-optical disks; and optical memory devices, for example, digital video disc (DVD), CD-ROM, DVD+/-R, DVD-RAM, DVD-ROM, HD-DVD, and BLURAY, and other optical memory technologies. The memory may store various objects or data, including caches, classes, frameworks, applications, modules, backup data, jobs, web pages, web page templates, data structures, database tables, repositories storing dynamic information, and any other appropriate information including any parameters, variables, algorithms, instructions, rules, constraints, or references thereto. Additionally, the memory may include any other appropriate data, such as logs, policies, security or access data, reporting files, as well as others. The processor and the memory can be supplemented by, or incorporated in, special purpose logic circuitry.

To provide for interaction with a user, implementations of the subject matter described in this specification can be implemented on a computer having a display device, for example, a cathode ray tube (CRT), liquid crystal display (LCD), light-emitting diode (LED), or plasma monitor, for displaying information to the user and a keyboard and a pointing device, for example, a mouse, trackball, or trackpad by which the user can provide input to the computer. Input may also be provided to the computer using a touchscreen, such as a tablet computer surface with pressure sensitivity, a multi-touch screen using capacitive or electric sensing, or other type of touchscreen. Other kinds of devices can be used to provide for interaction with a user as well; for example, feedback provided to the user can be any form of sensory feedback, for example, visual feedback, auditory feedback, or tactile feedback; and input from the user can be received in any form, including acoustic, speech, or tactile input. In addition, a computer can interact with a user by sending documents to and receiving documents from a device that is used by the user; for example, by sending web pages to a web browser on a user's client device in response to requests received from the web browser.

The term "graphical user interface," or "GUI," may be used in the singular or the plural to describe one or more graphical user interfaces and each of the displays of a particular graphical user interface. Therefore, a GUI may represent any graphical user interface, including but not limited to, a web browser, a touch screen, or a command line interface (CLI) that processes information and efficiently presents the information results to the user. In general, a GUI may include a plurality of user interface (UI) elements, some or all associated with a web browser, such as interactive fields, pull-down lists, and buttons. These and other UI elements may be related to or represent the functions of the web browser.

Implementations of the subject matter described in this specification can be implemented in a computing system that includes a back-end component, for example, as a data server, or that includes a middleware component, for example, an application server, or that includes a front-end component, for example, a client computer having a graphical user interface or a Web browser through which a user can interact with some implementations of the subject matter described in this specification, or any combination of one or more such back-end, middleware, or front-end components. The components of the system can be interconnected by any form or medium of wireline or wireless digital data communication (or a combination of data communication), for example, a communication network. Examples of communication networks include a local area network (LAN), a radio access network (RAN), a metropolitan area network (MAN), a wide area network (WAN), Worldwide Interoperability for Microwave Access (WIMAX), a wireless local area network (WLAN) using, for example, 802.11 a/b/g/n or 802.20 (or a combination of 802.11x and 802.20 or other protocols consistent with this disclosure), all or a portion of the Internet, or any other communication system or systems at one or more locations (or a combination of communication networks). The network may communicate with, for example, Internet Protocol (IP) packets, Frame Relay frames, Asynchronous Transfer Mode (ATM) cells, voice, video, data, or other suitable information (or a combination of communication types) between network addresses.

The computing system can include clients and servers. A client and server are generally remote from each other and typically interact through a communication network. The relationship of client and server arises by virtue of computer programs running on the respective computers and having a client-server relationship to each other.

Cluster file system involved in this invention can be any file system type accessible from multiple servers for read and update. Locking or consistency tracking is not necessary in this invention since the locking of exchange file system can be done at application layer. Furthermore, Unicode data files are different from non-Unicode data files.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented, in combination, in a single implementation. Conversely, various features that are described in the context of a single implementation can also be implemented in multiple implementations, separately, or in any suitable sub-combination. Moreover, although previously described features may be described as acting in certain combinations and even initially claimed as such, one or more features from a claimed combination can, in some cases, be excised from the combination, and the claimed combination may be directed to a sub-combination or variation of a sub-combination.

Particular implementations of the subject matter have been described. Other implementations, alterations, and permutations of the described implementations are within the scope of the following claims as will be apparent to those skilled in the art. While operations are depicted in the drawings or claims in a particular order, this should not be understood as requiring that such operations be performed in the particular order shown or in sequential order, or that all illustrated operations be performed (some operations may be considered optional), to achieve desirable results. In certain circumstances, multitasking or parallel processing (or a combination of multitasking and parallel processing) may be advantageous and performed as deemed appropriate.

Moreover, the separation or integration of various system modules and components in the previously described implementations should not be understood as requiring such separation or integration in all implementations, and it should be understood that the described program components and systems can generally be integrated together in a single software product or packaged into multiple software products.

Accordingly, the previously described example implementations do not define or constrain this disclosure. Other changes, substitutions, and alterations are also possible without departing from the scope of this disclosure.

Furthermore, any claimed implementation is considered to be applicable to at least a computer-implemented method; a non-transitory, computer-readable medium storing computer-readable instructions to perform the computer-implemented method; and a computer system comprising a computer memory interoperably coupled with a hardware processor configured to perform the computer-implemented method or the instructions stored on the non-transitory, computer-readable medium.

## Claims

1. A computer-implemented method for storing and managing model structural data in a database using a hash table (300) that is stored in the database, comprising:
calculating (302) a checksum for the model structural data, wherein the model structural data is produced from a reservoir simulation study;
querying (304) the hash table for the checksum;
when a determination is made that the checksum exists in the hash table, generating (308) soft links to physical locations of reservoir structure files containing the model structural data; and
when a determination is made that the checksum does not exist in the hash table:
generating (310) new reservoir structure files for the model structural data and storing the new reservoir structure files in the database;
generating (312) a new hash table entry containing record information identifying contents of the new reservoir structure files, wherein the record information comprises a checksum and physical locations of the new reservoir structure files; and
updating (314) the hash table stored in the database with the new hash table entry.

2. The computer-implemented method of claim 1, wherein the reservoir structure files store grid data.

3. The computer-implemented method of claim 2, wherein the grid data is stored in a format selected from a group comprising a cell-centered format, a corner-point geometry format, and an unstructured format.

4. The computer-implemented method of claim 3, wherein the unstructured format is a perpendicular bisector, PEBI, gridding format.

5. The computer-implemented method of claim 1, wherein the model structural data and the reservoir simulation study are associated with an oil well reservoir.

6. The computer-implemented method of claim 1, wherein the record information further includes a sequence, a date added, and simulation run information.

7. The computer-implemented method of claim 1, wherein querying the hash table for the checksum includes querying the hash table for one or more of a field name, a grid name, a checksum, a physical location on disk, or an activity status.

8. A non-transitory, computer-readable medium storing one or more instructions executable by a computer system to perform operations comprising the method of any one of claims 1 to 7.

9. A computer-implemented system, comprising:
one or more processors; and
a non-transitory computer-readable storage medium coupled to the one or more processors and storing programming instructions for execution by the one or more processors, the programming instructions instruct the one or more processors to perform operations comprising the method of any one of claims 1 to 7.

## Patentansprüche

1. Computerimplementiertes Verfahren zum Speichern und Verwalten von Modellstrukturdaten in einer Datenbank unter Verwendung einer Hash-Tabelle (300), die in der Datenbank gespeichert ist, umfassend:
Berechnen (302) einer Prüfsumme für die Modellstrukturdaten, wobei die Modellstrukturdaten anhand einer Reservoirsimulationsstudie erzeugt werden; Abfragen (304) der Hash-Tabelle nach der Prüfsumme;
wenn bestimmt wird, dass die Prüfsumme in der Hash-Tabelle existiert, Erzeugen (308) von Soft-Links zu physischen Orten von Reservoirstrukturdateien, die die Modellstrukturdaten enthalten; und
wenn bestimmt wird, dass die Prüfsumme in der Hash-Tabelle nicht existiert:
Erzeugen (310) neuer Reservoirstrukturdateien für die Modellstrukturdaten und Speichern der neuen Reservoirstrukturdateien;
Erzeugen (312) eines neuen Hash-Tabellen-Eintrags, der Aufzeichnungsinformationen enthält, die Inhalte der neuen Reservoirstrukturdateien identifizieren, wobei die Aufzeichnungsinformationen eine Prüfsumme und physische Orte der neuen Reservoirstrukturdateien umfassen; und
Aktualisieren (314) der in der Datenbank gespeicherten Hash-Tabelle mit dem neuen Hash-Tabellen-Eintrag.

2. Computerimplementiertes Verfahren nach Anspruch 1, wobei die Reservoirstrukturdateien Gitterdaten speichern.

3. Computerimplementiertes Verfahren nach Anspruch 2, wobei die Gitterdaten in einem aus einer Gruppe umfassend ein zellenzentriertes Format, ein Eckpunktgeometrieformat und ein unstrukturiertes Format ausgewählten Format gespeichert werden.

4. Computerimplementiertes Verfahren nach Anspruch 3, wobei das unstrukturierte Format ein Mittelsenkrechten- bzw. PEBI (Perpendicular-Bisector)-Gitterformat ist.

5. Computerimplementiertes Verfahren nach Anspruch 1, wobei die Modellstrukturdaten und die Reservoirsimulationsstudie mit einem Ölbohrreservoir assoziiert sind.

6. Computerimplementiertes Verfahren nach Anspruch 1, wobei die Aufzeichnungsinformationen ferner eine Sequenz, ein hinzugefügtes Datum und Simulationsablaufinformationen beinhalten.

7. Computerimplementiertes Verfahren nach Anspruch 1, wobei das Abfragen der Hash-Tabelle nach der Prüfsumme Abfragen der Hash-Tabelle nach einem Feldnamen und/oder einem Gitternamen und/oder einer Prüfsumme und/oder einem physischen Ort auf einer Platte und/oder einem Aktivitätsstatus umfasst.

8. Nichtflüchtiges computerlesbares Medium, das eine oder mehrere Anweisungen speichert, die durch ein Computersystem ausführbar sind, um Vorgänge durchzuführen, die das Verfahren nach einem der Ansprüche 1 bis 7 umfassen.

9. Computerimplementiertes System, das Folgendes umfasst:
einen oder mehrere Prozessoren; und
ein nichtflüchtiges computerlesbares Speichermedium, das mit dem einen oder den mehreren Prozessoren gekoppelt ist und Programmieranweisungen zum Ausführen durch den einen oder die mehreren Prozessoren speichert, wobei die Programmieranweisungen den einen oder die mehreren Prozessoren zum Durchführen von Vorgängen, die das Verfahren nach einem der Ansprüche 1 bis 7 umfassen, anweisen.

## Revendications

1. Procédé, mis en œuvre par ordinateur, de stockage et de gestion de données structurales de modèle dans une base de données à l'aide d'une table de hachage (300) qui est stockée dans la base de données, comprenant :
le calcul (302) d'une somme de contrôle pour les données structurales de modèle, les données structurales de modèle étant produites à partir d'une étude de simulation de réservoir ;
l'interrogation (304) de la table de hachage à la recherche de la somme de contrôle ;
en cas de détermination de la présence de la somme de contrôle dans la table de hachage, la génération (308) de liens symboliques vers des emplacements physiques de fichiers de structure de réservoir contenant les données structurales de réservoir ; et
en cas de détermination de l'absence de la somme de contrôle dans la table de hachage :
la génération (310) de nouveaux fichiers de structure de réservoir pour les données structurales de modèle et le stockage des nouveaux fichiers de structure de réservoir dans la base de données ;
la génération (312) d'une nouvelle entrée de table de hachage contenant des informations d'enregistrement identifiant des contenus des nouveaux fichiers de structure de réservoir, les informations d'enregistrement comprenant une somme de contrôle et des emplacements physiques des nouveaux fichiers de structure de réservoir ; et
la mise à jour (314) de la table de hachage stockée dans la base de données par la nouvelle entrée de table de hachage.

2. Procédé mis en œuvre par ordinateur selon la revendication 1, dans lequel les fichiers de structure de réservoir stockent des données de maille.

3. Procédé mis en œuvre par ordinateur selon la revendication 2, dans lequel les données de maille sont stockées dans un format sélectionné dans un groupe comprenant un format centré sur la cellule, un format dit CPG pour Corner-Point Geometry, et un format non structuré.

4. Procédé mis en œuvre par ordinateur selon la revendication 3, dans lequel le format non structuré est un format de maillage dit PEBI pour Perpendicular Bisector.

5. Procédé mis en œuvre par ordinateur selon la revendication 1, dans lequel les données structurales de modèle et l'étude de simulation de réservoir sont associées à un réservoir d'un puits de pétrole.

6. Procédé mis en œuvre par ordinateur selon la revendication 1, dans lequel les informations d'enregistrement comportent en outre une séquence, un date ajoutée, et des informations d'exécution de simulation.

7. Procédé mis en œuvre par ordinateur selon la revendication 1, dans lequel l'interrogation de la table de hachage à la recherche de la somme de contrôle comporte l'interrogation de la table de hachage à la recherche d'un nom de champ et/ou d'un nom de maille et/ou d'une somme de contrôle et/ou d'un emplacement physique sur disque et/ou d'un état d'activité.

8. Support non transitoire lisible par ordinateur stockant une ou plusieurs instructions exécutables par un système ordinateur pour réaliser des opérations comprenant le procédé selon l'une quelconque des revendications 1 à 7.

9. Système mis en œuvre par ordinateur, comprenant :
un ou plusieurs processeurs ; et
un support de stockage non transitoire lisible par ordinateur couplé aux un ou plusieurs processeurs et stockant des instructions de programmation destinées à être exécutées par les un ou plusieurs processeurs, les instructions de programmation donnant instruction aux un ou plusieurs processeurs de réaliser des opérations comprenant le procédé selon l'une quelconque des revendications 1 à 7.
